# EUROPEAN PATENT SPECIFICATION

(11) **EP 4 027 376 B1**
(45) Date of publication and mention of the grant of the patent: **06.05.2026**
(21) Application number: 21192524.3
(22) Date of filing: 23.08.2021
(51) Int. Cl.: H01L 21/768, H01L 23/522, H01L 23/528, H01L 23/532

(54) **VIA CONNECTIONS FOR STAGGERED INTERCONNECT LINES**
VIAS FÜR VERSETZT ANGEORDNETE VERBINDUNGSLEITUNGEN
CONNEXIONS VERTICALES POUR DES LIGNES D'INTERCONNEXION DÉCALÉES

(30) Priority: 24.09.2020 US 202017031825
(43) Date of publication of application: 13.07.2022
(73) Proprietor: Intel Corporation, Santa Clara, CA 95054 (US)
(72) Inventor: JEZEWSKI, Christopher, Portland, OR 97229 (US); LIN, Kevin, Beaverton, OR 97006 (US)
(74) Representative: HGF

(56) References cited:
- EP-A1- 3 439 031
- US-A1- 2005 258 498
- US-A1- 2018 211 870
- US-B1- 6 392 299

## Description

### TECHNICAL FIELD

Embodiments of the disclosure pertain to staggered interconnect lines and, in particular, to via connections for staggered interconnect lines.

### BACKGROUND

Low-k interlayer dielectrics (ILDs) and air gaps are used between structures in various interconnect technologies in order to reduce line-to-line capacitance as a means of improving overall performance. Interconnect structures that use low-k ILDs trade off improvements in line-to-line capacitance with reductions in patternability and mechanical stability and thus can be difficult to integrate. For copper layers, the use of air-gaps necessitates a moderate-k etch stop to hermetically seal the copper and prevent it from oxidizing. However, the etch stop material fills space between interconnect lines and reduces the overall capacitance benefit.

US 6 392 299 B1 discloses an interconnect level that includes upper and lower partial levels having respective conductive lines offset heightwise from each other.

### SUMMARY

Embodiments of the invention are set out in the appended claims.

### BRIEF DESCRIPTION OF THE DRAWINGS

FIG. 1 illustrates an interconnect structure according to a previous approach.
FIG. 2A illustrates a staggered line interconnect structure according to an embodiment.
FIG. 2B illustrates an interconnect structure that includes staggered lines and air-gaps in a staggered line according to an embodiment.
FIG. 2C illustrates an interconnect structure that includes staggered lines with air-gaps in each of the staggered lines according to an embodiment.
FIG. 3A illustrates via connections according to a previous approach.
FIG. 3B illustrates via connections according to according to an embodiment.
FIGS. 3C and 3D illustrate via connections according to according to an embodiment.
FIGS. 4A-4K illustrate cross-sections of an interconnect structure at stages during the fabrication of the interconnect structure according to an embodiment.
FIGS. 5A-5D illustrate cross-sections of an interconnect structure at stages during the fabrication of the interconnect structure according to an embodiment.
FIG. 6 illustrates a cross-section of an interconnect structure according to an embodiment.
FIGS. 7A-7L illustrate cross-sections of an interconnect structure at stages during the fabrication of the interconnect structure according to an embodiment.
FIGS. 8A-8M illustrate different architectures of interconnect structures according to an embodiment.
FIG. 9 illustrates a flowchart of a method for forming interconnect structures according to an embodiment.
FIG. 10 illustrates a schematic of a computer system according to an embodiment.
FIG. 11 illustrates an interposer that includes one or more implementations of the embodiments.

### DESCRIPTION OF THE EMBODIMENTS

Via connections for staggered interconnect lines are described. It should be appreciated that although embodiments are described herein with reference to example staggered interconnect line implementations, the disclosure is more generally applicable to staggered interconnect line implementations as well as other type staggered interconnect lines implementations. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The use of low-k interlayer dielectrics (ILDs) and air gaps between structures in interconnect technologies to reduce line-to-line and layer-to-layer capacitance in order to improve overall performance is a feature of previous approaches. Interconnect structures that use low-k ILDs trade off improvements in line-to-line capacitance with reductions in patternability and mechanical stability and are thus difficult to integrate. Air-gaps have been used in some products for 80nm and 160nm pitches. For copper layers, the use of air-gaps necessitates a moderate-k etch stop to hermetically seal the copper and prevent it from oxidizing. However, the etch stop material can fill space between interconnect lines and reduce the overall capacitance benefit.

An approach that addresses the shortcomings of previous approaches is disclosed herein. For example, as part of a disclosed process, adjacent interconnect lines are staggered. In addition, optionally, an air gap can be formed adjacent each interconnect line in order to obtain the maximum reductions in line-to-line capacitance (e.g., the maximum benefit).

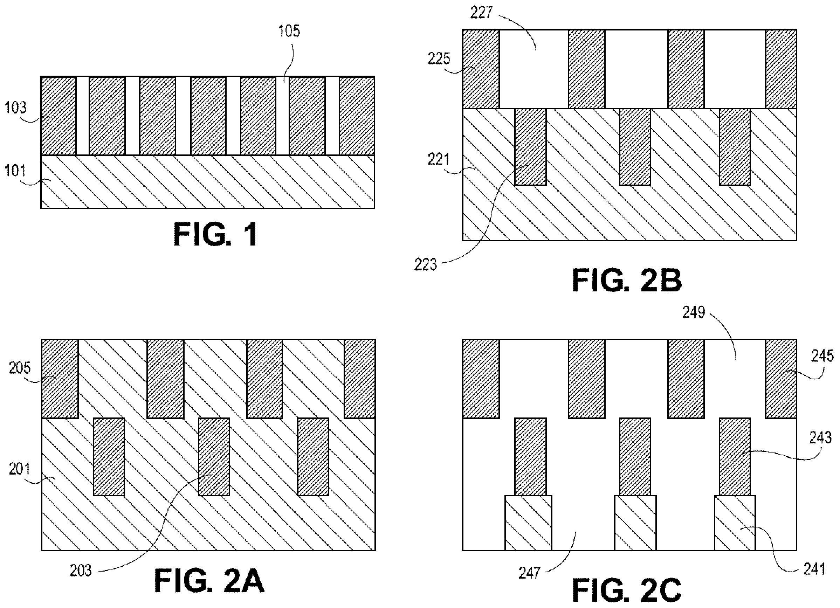

FIG. 1 illustrates an interconnect structure that includes horizontally aligned interconnect lines according to a previous approach. FIG. 1 shows dielectric 101, interconnect lines 103 and air-gaps 105.

Referring to FIG. 1, the interconnect lines 103 are formed above the dielectric 101. The interconnect lines 103 are separated by the air-gaps 105. The air-gaps 105 are used to reduce line-to-line capacitance. A drawback of this approach is that for copper interconnects, as a part of forming the adjacent air-gaps 105, the use of a moderate-k etch stop layer is required in order to hermetically seal the copper and to prevent the copper from oxidizing. However, the etch stop material can occupy space between the lines which can reduce the overall benefit.

FIG. 2A illustrates a staggered line interconnect structure. As shown in FIG. 2A, the staggered line interconnect structure can include dielectric 201, interconnect lines 203, and interconnect lines 205. Referring to FIG. 2A, the interconnect lines 203 and the interconnect lines 205 can be formed in the dielectric 201. Moreover, in FIG. 2A the interconnect lines 203 and the interconnect lines 205 can be staggered. In particular, the interconnect lines 205 can be formed in a row above the interconnect lines 203 and the interconnect lines 205 can be laterally offset from the interconnect lines 203 formed below them. For example, as shown in FIG. 2A, the individual interconnect lines of the interconnect lines 203 are formed below and between the individual interconnect lines of the interconnect lines 205. The staggering of the interconnect lines 203 and the interconnect lines 205 is used to reduce line-to-line capacitance in the interconnect structure.

FIG. 2B illustrates an interconnect structure that includes staggered lines and air-gaps in one of the staggered lines. In FIG. 2B the interconnect structure includes dielectric 221, interconnect lines 223, interconnect lines 225 and air-gaps 227.

Referring to FIG. 2B, the interconnect lines 223 can be formed in the dielectric 221 and the interconnect lines 225 can be formed above the dielectric 221. In addition, the interconnect lines 225 can be separated by the air-gaps 227. In FIG. 2B the interconnect lines 223 and the interconnect lines 225 can be staggered. In particular, the interconnect lines 225 can be formed in a row above the interconnect lines 223 and can be laterally offset from the interconnect lines 223 with the interconnect lines 223 being formed underneath the air-gaps 227. For example, the individual interconnect lines of the interconnect lines 223 can be formed below and between the individual interconnect lines of the interconnect lines 225. The staggering of the interconnect lines 223 and the interconnect lines 225, and the use of the air-gaps 227, operate together to reduce line-to-line capacitance in the interconnect structure.

FIG. 2C illustrates an interconnect structure that includes staggered lines with air-gaps in each of the staggered lines. As shown in FIG. 2C, the interconnect structure can include dielectric 241, interconnect lines 243, interconnect lines 245, air-gaps 247 and air-gaps 249.

Referring to FIG. 2C, the interconnect lines 243 can be formed above the dielectric 241 and below the air-gaps 249 between the individual lines of the interconnect lines 245. Moreover, the interconnect lines 245 can be formed above the air-gaps 247 that are formed between the individual lines of the interconnect lines 243. In FIG. 2C the interconnect lines 243 and the interconnect lines 245 can be staggered. In particular, the interconnect lines 245 can be formed in a row above the interconnect lines 243 and can be laterally offset from the interconnect lines 243. Both the staggering of the interconnect lines 243 and the interconnect lines 245, and the use of the air-gaps 247 and the air-gaps 249, operate to reduce line-to-line capacitance in the interconnect structure.

In an aspect, via connections for staggered interconnects are described. It is to be appreciated that staggered interconnects may require some via connections to be longer, thus increasing via resistance under conventional conditions.

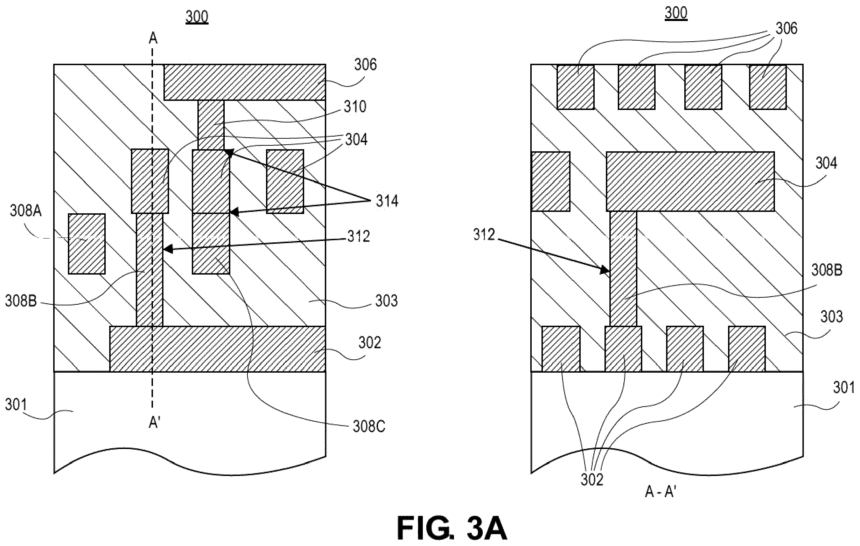

FIG. 3A illustrates via connections according to a previous approach.

Referring to FIG. 3A, a metallization structure 300 is shown from a first cross-sectional view (left-hand side) and a second cross-sectional view (right-hand side), the second cross-sectional view taken through the A-A' axis of the first cross-sectional view. The metallization structure 300 includes multiple layers of metal lines above a substrate 301. For example, metal line layers 302, 304 and 306 with intervening metal line layers 308A and 310 in a dielectric layer 303. A relatively longer via 308B is associated with a longer via resistance. In another case, multiple barriers 314 are associated with increased via resistance.

Referring again to FIG. 3A, multiple barriers increase via resistance, and a longer via increases via resistance. There is a trade-off for capacitance/resistance benefits with staggered interconnects with via resistance penalty. Increased via resistance comes at a performance decrease which may offset the performance improvement from staggered interconnects.

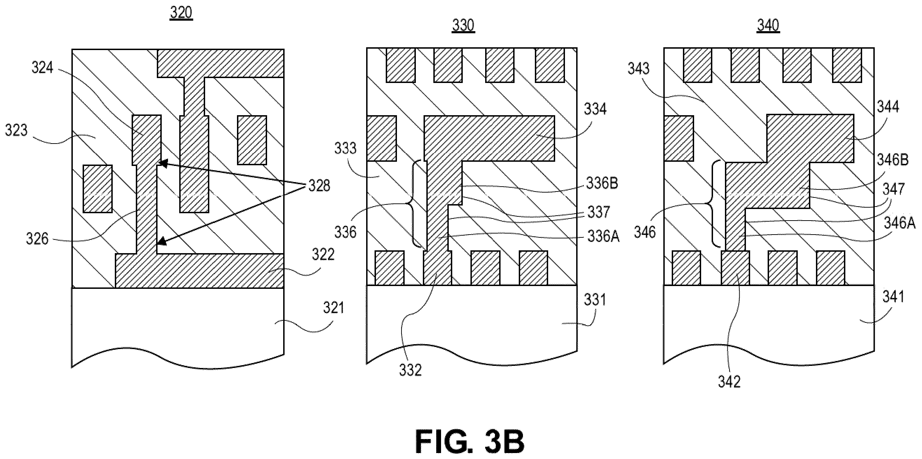

FIG. 3B illustrates via connections according to an embodiment.

Referring to FIG. 3B, a metallization structure 320 includes multiple layers of metal lines in a dielectric layer 323 above a substrate 321. In an example, metal lines 322 and 324 are coupled by a relatively longer via 326. In an embodiment, the relatively longer via 326 is a liner-less or barrier-less via. That is, in one embodiment, an interconnect structure includes a via coupling an individual interconnect of a first plurality of interconnects to an individual interconnect of a second plurality of interconnects, wherein the via is a barrier-less via. In one embodiment, alternative metals are used to replace copper (Cu), such as Mo, Ru, W which do not require barrier/liner materials and can thus render the metallization bottomless. In one embodiment, staggered interconnects with bottomless via barriers are implemented to reduce the via resistance by reducing the number of interfaces. In an embodiment, a barrier-less via can be implemented to enable optimization and performance improvements of staggered interconnects without via resistance penalty.

Referring again to FIG. 3B, a metallization structure 330 includes multiple layers of metal lines in a dielectric layer 333 above a substrate 331. In an example, metal lines 332 and 334 are coupled by a varied width via 336 having a narrower lower portion 336A and a wider upper portion 336B. Different from a via with tapered straight sidewalls, in an embodiment, the varied width via 336 has at least one non-linear sidewall 337. A metallization structure 340 includes multiple layers of metal lines in a dielectric layer 343 above a substrate 341. In an example, metal lines 342 and 344 are coupled by a varied width via 346 having a narrower lower portion 346A and a wider upper portion 346B. In an embodiment, the varied width via 346 has at least one non-linear sidewall 347.

That is, in one embodiment, an interconnect structure includes a via coupling an individual interconnect of a first plurality of interconnects to an individual interconnect of a second plurality of interconnects, where the via has a non-linear sidewall. In one embodiment, geometries and routing selections can be implemented to reduce via resistance by increasing the area of the effective "via" connection. In an embodiment, a varied width via can be implemented to enable optimization and performance improvements of staggered interconnects without via resistance penalty.

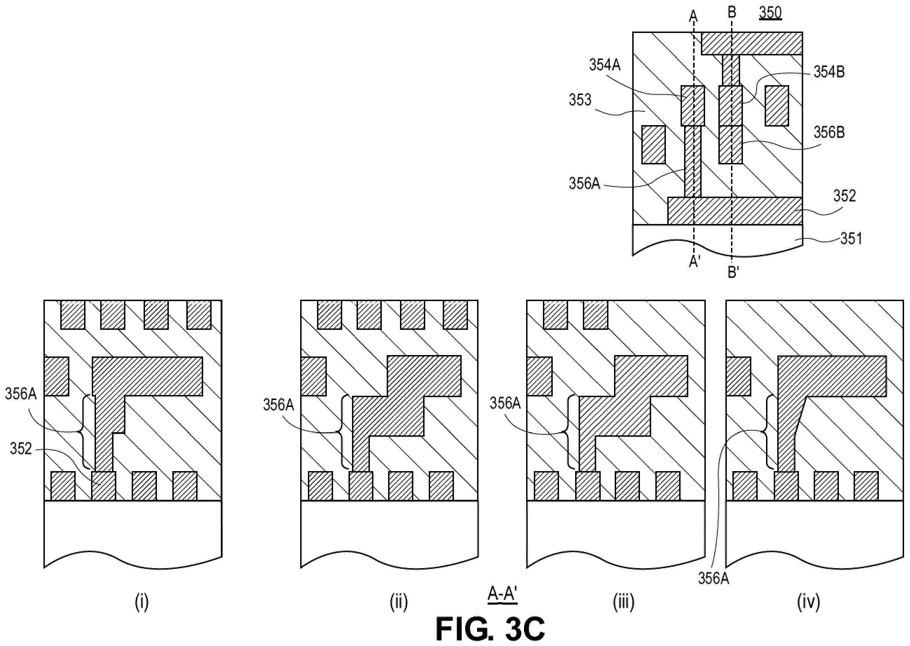

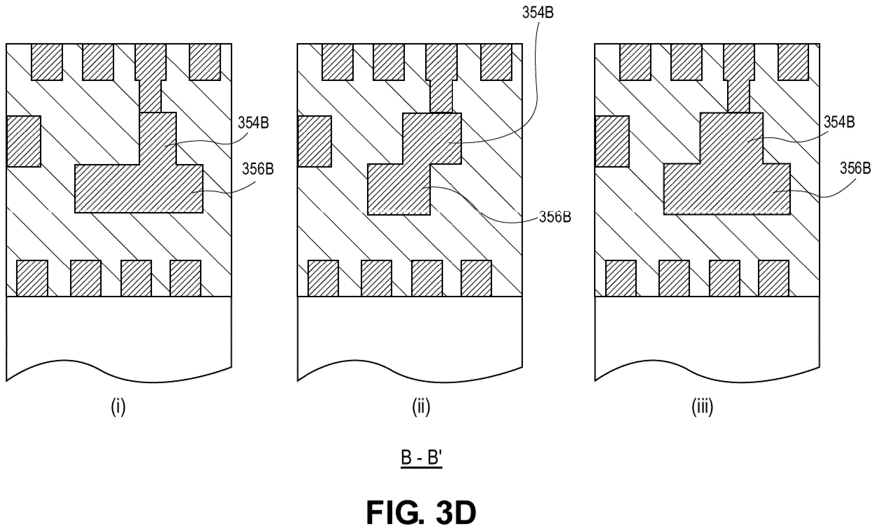

FIGS. 3C and 3D illustrate via connections according to according to an embodiment.

Referring to FIG. 3C, a metallization structure 350 is shown from a first cross-sectional view (top image) and second cross-sectional views of a variety of structural options (i, large via), (ii, multi-layer routing), (iii, large via) and (iv, partially tapered via), the second cross-sectional views taken through the A-A' axis of the first cross-sectional view. FIG. 3D illustrates third cross-sectional views of a variety of structural options (i, large via), (ii, multi-layer routing) and (iii, large via), the third cross-sectional views taken through the B-B' axis of the first cross-sectional view of FIG. 3C.

The metallization structure 350 includes multiple layers of metal lines in a dielectric layer 353 above a substrate 351. For example, metal lines 352 and 354A are coupled by a relatively longer via 356A. Metal line 354B is coupled to metal line 356B. Thus, a variety of routing geometry options may be implemented for reduced via resistance.

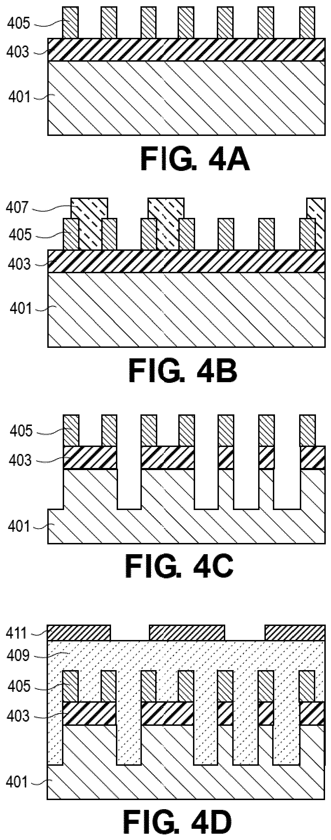

FIGS. 4A-4K show cross-sections of an interconnect structure at stages during the fabrication of an interconnect structure comprising staggered metal lines. In FIG. 4A, the initial structure includes interlayer dielectric (ILD) 401, dielectric 403 and grating patterned material 405. It is to be appreciated that, in accordance with one or more embodiments, one or more via connections such as described in association with FIGS. 3B, 3C and 3D are used to connect interconnect lines of vertically adjacent metallization layers formed using the approach described below in association with FIGS. 4A-4K.

Referring to FIG. 4A, the grating patterned material 405 remains on the surface of the interconnect structure after a pattern transfer is performed using grating lithography. Grating lithography involves the transfer of a grating pattern to the structure. The grating lithography can include but is not limited to electron beam lithography, X-ray lithography, projection lithography, contact exposure or proximity exposure. The grating lithography can be performed in other manners. Gratings can be formed using pitch division, multi-patterning or other techniques. Such techniques can include but are not limited to self-aligned double patterning (SADP), self-aligned quadruple patterning (SAQP), self-aligned octuple patterning (SAOP), litho etch litho etch (LELE), or litho etch litho etch litho etch (LELELE).

Referring to FIG. 4B, subsequent to one or more operations that result in the structure shown in FIG. 4A, a pattern transfer is performed using plug lithography. Plug lithography involves the transfer of a plug pattern 407 to the interconnect structure. The plug lithography can include but is not limited to electron beam lithography, X-ray lithography, projection lithography, contact exposure or proximity exposure.

Referring to FIG. 4C, subsequent to one or more operations that result in the structure shown in FIG. 4B, an etch into the ILD 401 is performed. The etch into the ILD 401 can be an anisotropic dry etch. Other manners of etching can be used such as isotropic or wet etching.

Referring to FIG. 4D, subsequent to one or more operations that result in the structure shown in FIG. 4C, a dielectric 409 is formed on the surface of the structure in exposed spaces. The dielectric 409 can be a spin-coated sacrificial hardmask. Thereafter, via lithography is performed where a via pattern 411 is transferred to the surface of the interconnect structure. The dielectric 409 can be formed by chemical vapor deposition (CVD), plasma enhanced chemical vapor deposition (PECVD), or atomic layer deposition (ALD). The dielectric 409 can be formed using other manners of forming a dielectric. The via lithography can be performed using electron beam lithography, X-ray lithography, projection lithography, contact exposure or proximity exposure. The via lithography can be performed in other suitable manners.

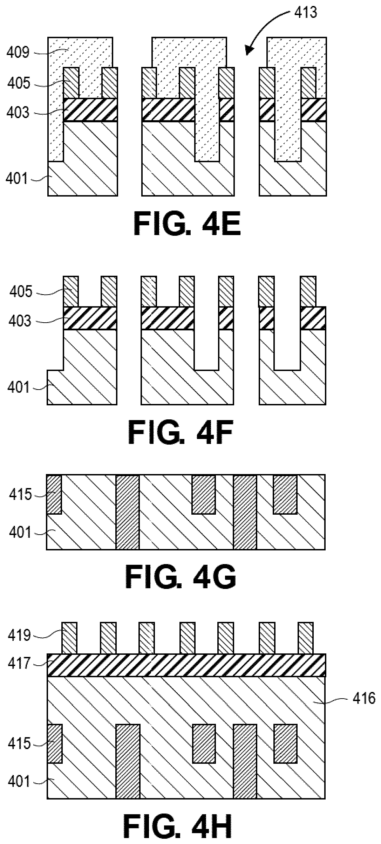

Referring to FIG. 4E, subsequent to one or more operations that result in the structure shown in FIG. 4D, a via etch is performed to form vias 413. The via etch can be a wet etch or a dry etch. The via etch can be an isotropic etch. In other embodiments, the via etch can be an anisotropic etch.

Referring to FIG. 4F, subsequent to one or more operations that result in the structure shown in FIG. 4E, a carbon hardmask (CHM) ash and cleans is performed. The cleaning can be performed to prevent contamination. The CHM ash and cleans results in the removal of the dielectric 409 and the via pattern 411

Referring to FIG. 4G, subsequent to one or more operations that result in the structure shown in FIG. 4F, a metal 415 is formed in the vias and trenches and a chemical mechanical polishing (CMP) is performed. The metal 415 can be formed in the vias and the trenches by electroplating or electroless plating, chemical vapor deposition (CVD), plasma enhanced chemical vapor deposition (PECVD), atomic layer deposition (ALD), or physical deposition processes. The metal can be formed in the vias and the trenches using any other suitable manner of forming the metal in the vias and the trenches. In addition, the dielectric 403 and the grating patterned material 405 are removed.

Referring to FIG. 4H, subsequent to one or more operations that result in the structure shown in FIG. 4G, an ILD deposition is performed and a pattern transfer is performed using grating lithography. As part of the ILD deposition and pattern transfer, ILD 416, dielectric 417 and grating patterned material 419 are formed on the interconnect structure. The ILD deposition can be performed by chemical vapor deposition (CVD), plasma enhanced chemical vapor deposition (PECVD), atomic layer deposition (ALD), or physical deposition processes. The ILD deposition can be performed using any other suitable manner of performing an ILD deposition. The grating lithography can be performed based on electron beam lithography, X-ray lithography, projection lithography, contact exposure or proximity exposure. The grating lithography can be performed using any other suitable manner of performing grating lithography.

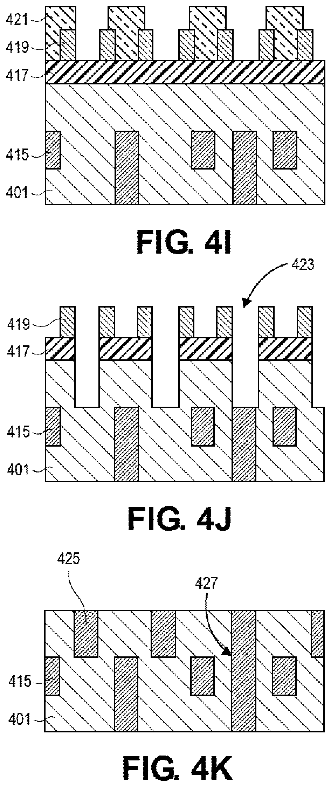

Referring to FIG. 4I, subsequent to one or more operations that result in the structure shown in FIG. 4H, a pattern transfer is performed using plug lithography where a plug pattern 421 is formed on the interconnect structure. The plug lithography used can include electron beam lithography, X-ray lithography, projection lithography, contact exposure or proximity exposure. The plug lithography used can include any other suitable manner of manner of performing plug lithography.

Referring to FIG. 4J, subsequent to one or more operations that result in the structure shown in FIG. 4I, an etch into the ILD is performed that forms vias 423. In an embodiment, the etch into the ILD can be a wet etch or a dry etch. The etch into the ILD can be an isotropic etch. The etch into the ILD can be an anisotropic etch. In addition, the plug pattern 421 can be removed.

Referring to FIG. 4K, subsequent to one or more operations that result in the structure shown in FIG. 4J, metal 425 and metal 427 is formed in the vias 423 and a CMP is performed. The metal 425 and 427 can be formed by plating, chemical vapor deposition (CVD), plasma enhanced chemical vapor deposition (PECVD), atomic layer deposition (ALD), or physical deposition processes. The metal can be formed using any other suitable manners of forming a metal. In addition, as part of the CMP, the ILD 416, the dielectric 417 and the grating patterned material 419 are removed.

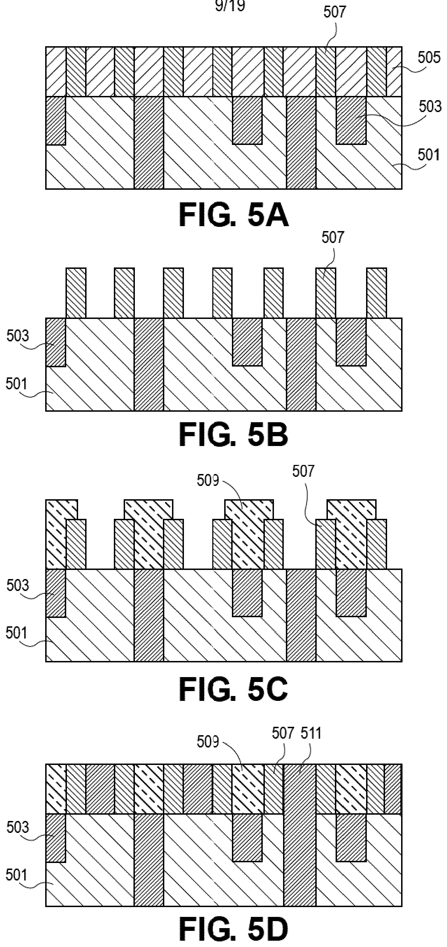

FIGS. 5A-5D illustrate cross-sections of a interconnect structure at stages during the fabrication of the interconnect structure comprising staggered metal lines. Referring to FIG. 5A, subsequent to a plurality of operations similar to those described with reference to FIGS. 4A-4G, a directed self-assembly (DSA) is performed. The DSA causes the formation of the grating pattern 507 and the dielectric material 505. The DSA can cause the formation of a self-aligned grating pattern. It is to be appreciated that, in accordance with one or more embodiments, one or more via connections such as described in association with FIGS. 3B, 3C and 3D are used to connect interconnect lines of vertically adjacent metallization layers formed using the approach described below in association with FIGS. 5A-5D.

Referring to FIG. 5B, subsequent to one or more operations that result in the structure shown in FIG. 5A, the DSA including the dielectric material 505 is removed such that it can be replaced with permanent material. After the removal of the dielectric material 505, the grating pattern 507 remains.

Referring to FIG. 5C, subsequent to one or more operations that result in the structure shown in FIG. 5B, a plug pattern 509 is formed on the structure. The plug pattern 509 can be formed by plug lithography. The plug lithography method can include electron beam lithography, X-ray lithography, projection lithography, contact exposure or proximity exposure. In other embodiments, the plug lithography method can include any suitable manner of manner of performing plug lithography.

Referring to FIG. 5D, after one or more operations that result in the structure shown in FIG. 5C, metal 511 is formed in the spaces defined by the plug patterning and a second CMP is performed to planarize the structure. The metal 511 can be formed by plating, chemical vapor deposition (CVD), plasma enhanced chemical vapor deposition (PECVD), atomic layer deposition (ALD), or physical deposition processes. The metal 511 can be formed using any other suitable manner of forming a metal in the spaces defined by plug patterning.

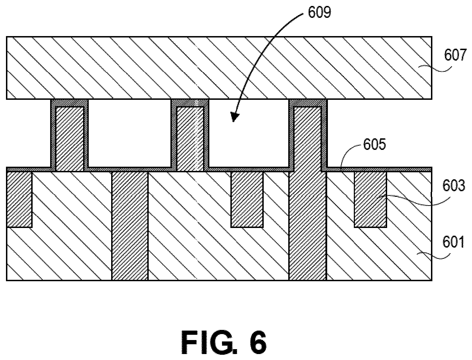

FIG. 6 is an illustration of a cross-section of a interconnect structure. Referring to FIG. 6, subsequent **to** operations similar to those shown in FIGS. 4A-4G, an air-gap etch, an etch stop deposition, and an ILD deposition is performed. In FIG. 6, the completed structure includes ILD 601, vias 603, etch stop 605, air-gaps 609 and capping layer 607 (formed from the aforementioned ILD deposition). It is to be appreciated that, in accordance with one or more embodiments, one or more via connections such as described in association with FIGS. 3B, 3C and 3D are used to connect interconnect lines of vertically adjacent metallization layers formed using the approach described below in association with FIG. 6.

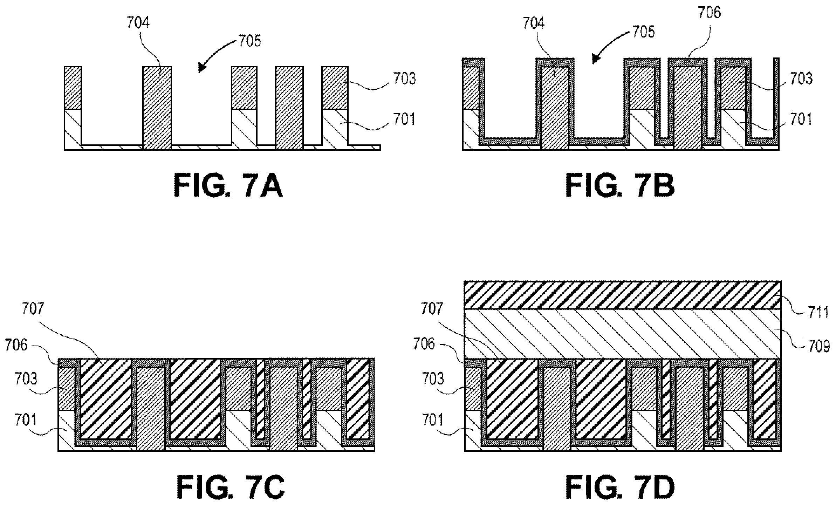

FIGS. 7A-7L is an illustration of a cross-section of a interconnect structure at stages during the fabrication of the interconnect structure comprising staggered metal lines. It is to be appreciated that, in accordance with one or more embodiments, one or more via connections such as described in association with FIGS. 3B, 3C and 3D are used to connect interconnect lines of vertically adjacent metallization layers formed using the approach described below in association with FIGS. 7A-7L.

Referring to FIG. 7A, subsequent to one or more operations similar to those described with reference to FIGS. 4A-4G, an air-gap etch and cleanse is performed. The resulting structure includes ILD 701, metal structure 703, extended metal structure 704, and air-gap 705. In an embodiment, the air-gap 705 etch can be a wet etch or a dry etch. In an embodiment, the air-gap 705 etch can be an isotropic etch. The air-gap 705 etch can be an anisotropic etch.

Referring to FIG. 7B, subsequent to one or more operations that result in the structure shown in FIG. 7A, a conformal deposition of etch stop 706 is performed. The conformal deposition of etch stop 706 can be performed by chemical vapor deposition (CVD), plasma enhanced chemical vapor deposition (PECVD), atomic layer deposition (ALD), or physical deposition processes. The etch stop deposition can be performed using any other suitable manner of performing etch stop deposition.

Referring to FIG. 7C, subsequent to one or more operations that result in the structure shown in FIG. 7B, a sacrificial material 707 fill and CMP is performed. The sacrificial material 707 fill can be performed using chemical vapor deposition (CVD), plasma enhanced chemical vapor deposition (PECVD), atomic layer deposition (ALD), or physical deposition processes. The sacrificial material fill 707 can be performed using any other suitable manner of performing a sacrificial material fill.

Referring to FIG. 7D, subsequent to one or more operations that result in the structure shown in FIG. 7C, a next layer ILD 709 and hard mask 711 deposition is performed. The next layer ILD 709 and hard mask 711 deposition can be performed using chemical vapor deposition (CVD), plasma enhanced chemical vapor deposition (PECVD), atomic layer deposition (ALD), or physical deposition processes. The next layer ILD 709 and hard mask 711 deposition can be performed using any other suitable manners of performing a next layer ILD 709 and hard mask 711 deposition.

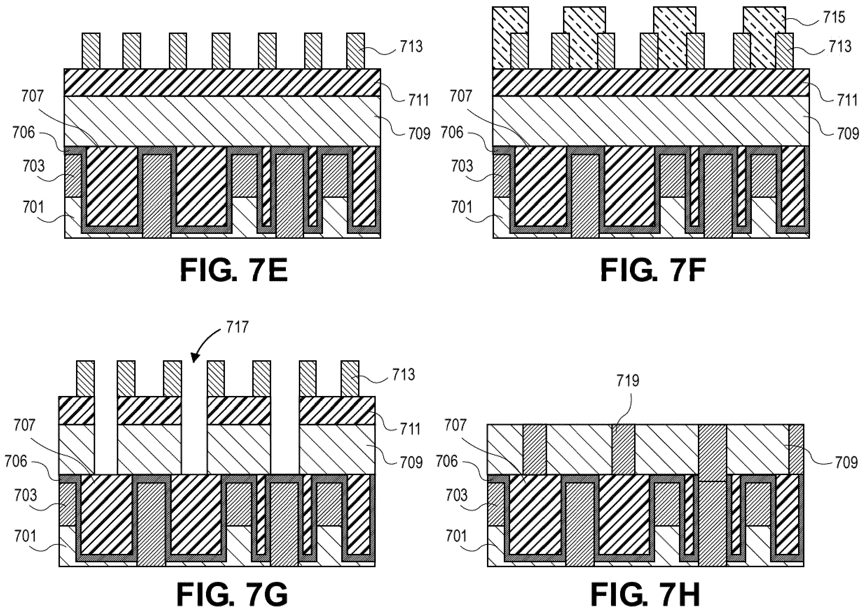

Referring to FIG. 7E, subsequent to one or more operations that result in the structure shown in FIG. 7D, a grating pattern 713 transfer is performed. The grating pattern 713 transfer can be performed by electron beam lithography, X-ray lithography, projection lithography, contact exposure or proximity exposure. The grating pattern 713 can be performed in any suitable manner of performing grating patterning.

Referring to FIG. 7F, subsequent to one or more operations that result in the structure shown in FIG. 7E, a plug pattern 715 transfer is performed. The plug pattern 715 transfer can be performed by electron beam lithography, X-ray lithography, projection lithography, contact exposure or proximity exposure. The plug pattern 715 transfer can be performed in any suitable manner of performing plug patterning.

Referring to FIG. 7G, subsequent to one or more operations that result in the structure shown in FIG. 7F, an etch transfer into the ILD 709 is performed. The etch transfer into the ILD 709 forms vias 717. The etch transfer into the ILD 709 can be a wet etch or a dry etch. The etch transfer into the ILD 709 can be isotropic. The etch transfer into the ILD 709 can be an anisotropic. In addition, the plug pattern 715 can be removed.

Referring to FIG. 7H, subsequent to one or more operations that result in the structure shown in FIG. 7G, metallization and CMP is performed. As part of the metallization, the metal structures 719 are formed. The metallization can be performed by chemical vapor deposition (CVD), plasma enhanced chemical vapor deposition (PECVD), atomic layer deposition (ALD), or physical deposition processes. The metallization can be performed using any other suitable manners of performing metallization. In addition, the hard mask 711 and grating pattern 713 can be removed.

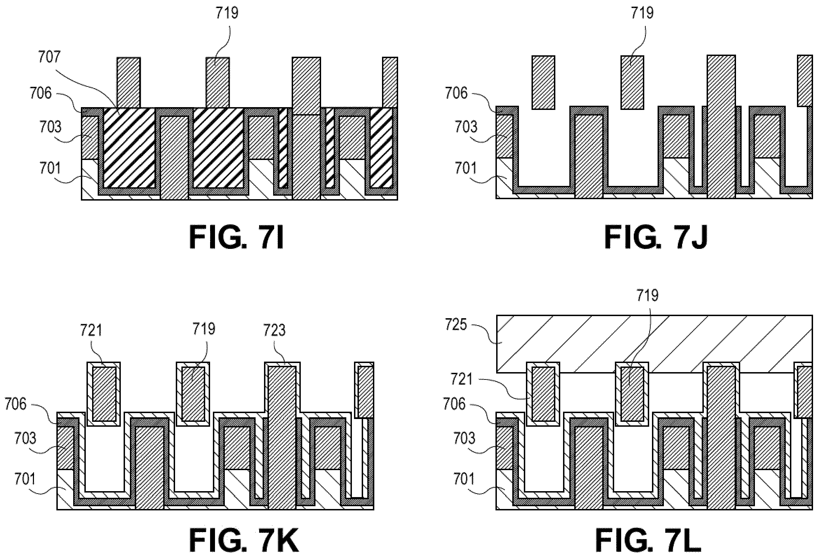

Referring to FIG. 7I, subsequent to one or more operations that result in the structure shown in FIG. 7H, an air-gap etch and cleanse is performed. The air-gap etch removes the remaining parts of the ILD 709. The air-gap etch can be a wet etch or a dry etch. The air-gap etch can be an isotropic etch. In other embodiments, the air-gap etch can be an anisotropic etch.

Referring to FIG. 7J, subsequent to one or more operations that result in the structure shown in FIG. 7I, sacrificial material 707 is removed. The sacrificial material 707 can be removed by a wet etch or a dry etch. The sacrificial material 707 can be removed by an isotropic etch.

Referring to FIG. 7K, subsequent to one or more operations that result in the structure shown in FIG. 7J, an etch stop 721 and 723 deposition is performed. The etch stop 721 surrounds the upper layer metal structures 719 and the etch stop 723 surrounds the lower layer metal structures 703 and the metal structures 706 that extend into the upper layer from the lower layer. The etch stop deposition can be performed using chemical vapor deposition (CVD), plasma enhanced chemical vapor deposition (PECVD), atomic layer deposition (ALD), or physical deposition processes. The etch stop deposition can be performed using any other suitable manners of performing an etch stop deposition.

Referring to FIG. 7L, subsequent to one or more operations that result in the structure shown in FIG. 7K, a capping layer 725 is formed. The capping layer 725 can be formed using chemical vapor deposition (CVD), plasma enhanced chemical vapor deposition (PECVD), atomic layer deposition (ALD), or physical deposition processes. The capping layer 725 can be formed using other suitable manners of forming a capping layer 725.

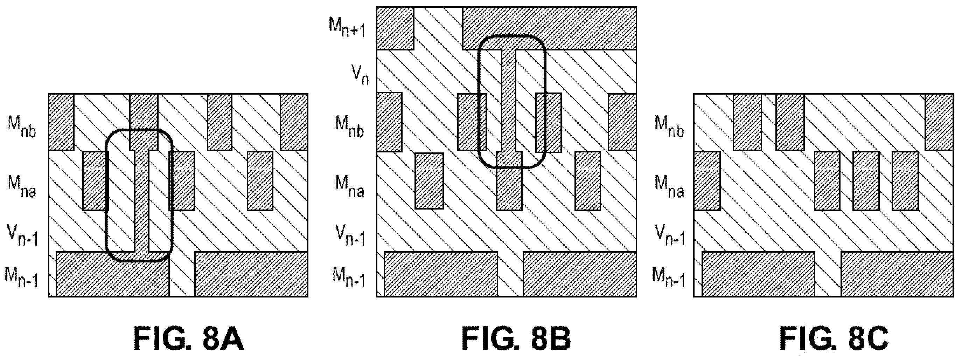

FIGS. 8A-8M illustrate various architectures of the staggered interconnect lines structure. It is to be appreciated that, in accordance with one or more embodiments, one or more via connections such as described in association with FIGS. 3B, 3C and 3D are used to connect interconnect lines of vertically adjacent metallization layers formed using the approach described below in association with FIGS. 8A-8M.

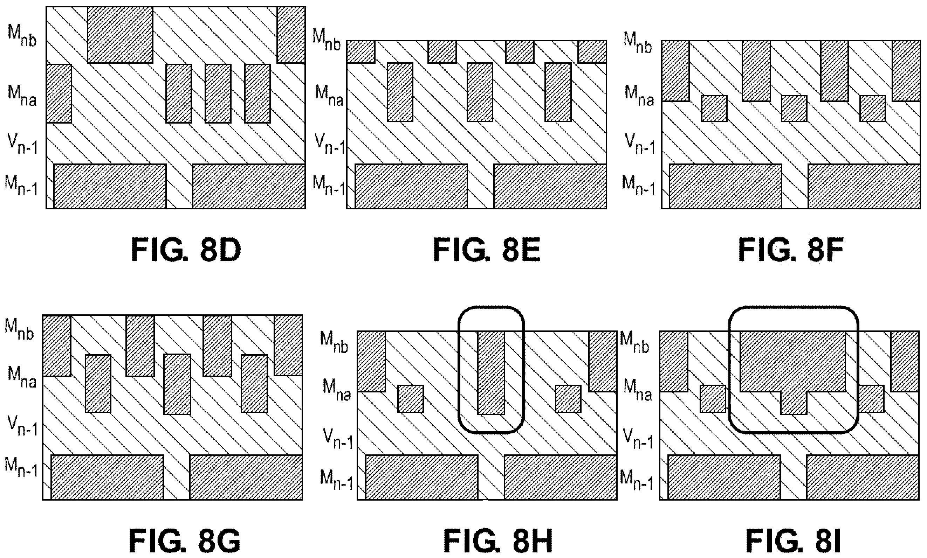

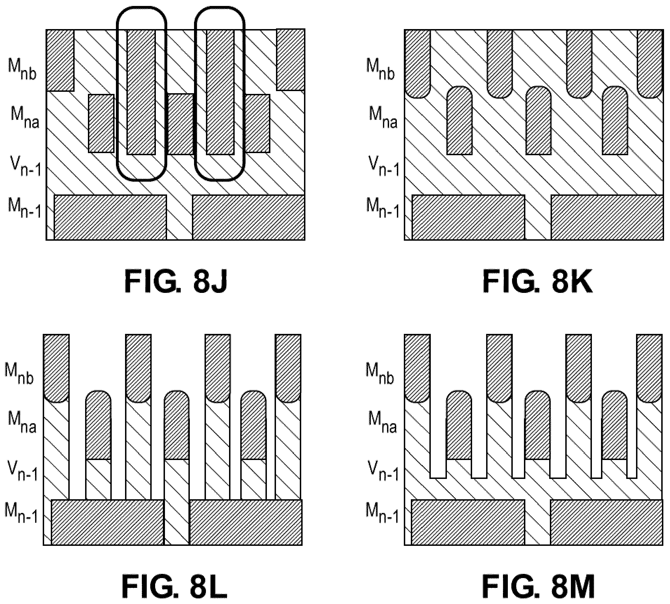

FIGS. 8A-8M show architectures having a range of layers that include Mₙ₋₁, Vₙ₋₁, Mₙₐ, M_{nb}, Vₙ, and Mₙ₊₁. FIG. 8A illustrates a staggered architecture that includes a via that connects M_{nb} to Mₙ₋₁. FIG. 8B illustrates a staggered architecture that includes a via that connects Mₙₐ to layer Mₙ₊₁. FIG. 8C illustrates a staggered architecture with different combinations of staggered lines. FIG. 8D illustrates a staggered architecture with lines having different widths and pitches. FIG. 8E illustrates a staggered architecture with lines Mₙₐ and M_{nb} having different heights. FIG. 8F illustrates a staggered architecture with lines Mₙₐ and M_{nb} having different heights. FIG. 8G illustrates a staggered architecture with lines Mₙₐ and M_{nb} including portions that vertically overlap. FIG. 8H illustrates a staggered architecture with double strapped lines that extend across Mₙₐ and M_{nb}. In an embodiment, the staggered architecture with double strapped lines can be configured to provide lower resistance such as for power and ground. FIG. 8I illustrates a staggered architecture with double strapped lines that includes both wide and narrow parts. FIG. 8J illustrates a staggered architecture with multiple double strapped lines for lowered resistance. FIG. 8K illustrates a staggered architecture having metal structures with rounded corners for lower capacitance. The rounded corners can include metal structure top corners or metal structure bottom corners. The rounded corners can be formed by performing an air-gap etch. The rounded corners can be formed by selective growth. FIG. 8L illustrates a staggered architecture with a deep air-gap etch (etch to Mₙ₋₁). FIG. 8M illustrates a staggered architecture with a deep air-gap etch (etch to Vₙ₋₁). As part of the fabrication of the interconnect structures, an etch stop between Mₙₐ and M_{nb} can assist in consistently landing the trenches. In addition, the top critical dimension can be wider than the bottom critical dimension to assist via landing.

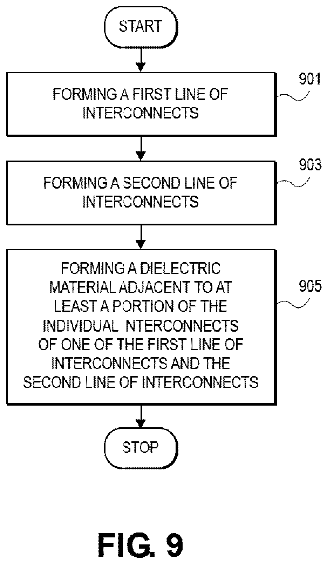

FIG. 9 illustrates a flowchart of a method for forming an interconnect structure according to an embodiment. The method includes at 901, forming a first line of interconnects. At 903, forming a second line of interconnects. The first line of interconnects and the second line of interconnects are staggered. For example, in an embodiment, the individual interconnects of the second line of interconnects are laterally offset from individual interconnects of the first line of interconnects. At 905, forming a dielectric material adjacent to at least a portion of the individual interconnects of one of the first line of interconnects and the second line of interconnects. In an embodiment, the interconnect structure can include air-gaps between the individual interconnects of the first line of interconnects. In an embodiment, the interconnect structure can include air-gaps between the individual interconnects of the second line of interconnects. In an embodiment, both the first line of interconnects and the second line of interconnects can include air-gaps between individual interconnects. In an embodiment, the first line of interconnects and the second line of interconnects can be at least partially surrounded by etch stop. In an embodiment, the interconnect structure can include a dielectric layer above the first line of interconnects.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, or zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, or conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, or aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, or silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), organosilicates such as silsesquioxane, siloxane, or organosilicate glass. The ILD layers may include pores or air-gaps to further reduce their dielectric constant.

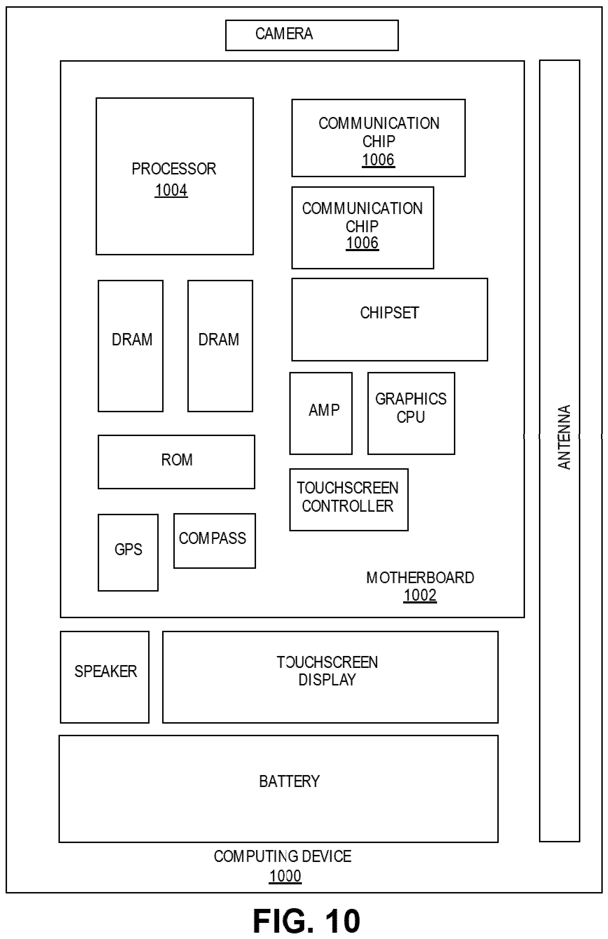

FIG. 10 illustrates a computing device 1000 in accordance with one implementation of the invention. The computing device 1000 houses a board 1002. The board 1002 may include a number of components, including but not limited to a processor 1004 and at least one communication chip 1006. The processor 1004 is physically and electrically coupled to the board 1002. In some implementations the at least one communication chip 1006 is also physically and electrically coupled to the board 1002. In further implementations, the communication chip 1006 is part of the processor 1004.

Depending on its applications, computing device 1000 may include other components that may or may not be physically and electrically coupled to the board 1002. These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1006 enables wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing device 1000 includes an integrated circuit die packaged within the processor 1004. In some implementations of the invention, the integrated circuit die of the processor includes one or more devices, such as via connections for staggered interconnect lines built in accordance with implementations of the invention. The term "processor" may refer to any device or portion of a device that processes electronic data from registers and/or memory to transform that electronic data into other electronic data that may be stored in registers and/or memory.

The communication chip 1006 also includes an integrated circuit die packaged within the communication chip 1006. In accordance with another implementation of the invention, the integrated circuit die of the communication chip includes one or more devices, such as via connections for staggered interconnect lines built in accordance with implementations of the invention.

In further implementations, another component housed within the computing device 1000 may contain an integrated circuit die that includes one or more devices, such as via connections for staggered interconnect lines built in accordance with implementations of the invention.

In various implementations, the computing device 1000 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 1000 may be any other electronic device that processes data.

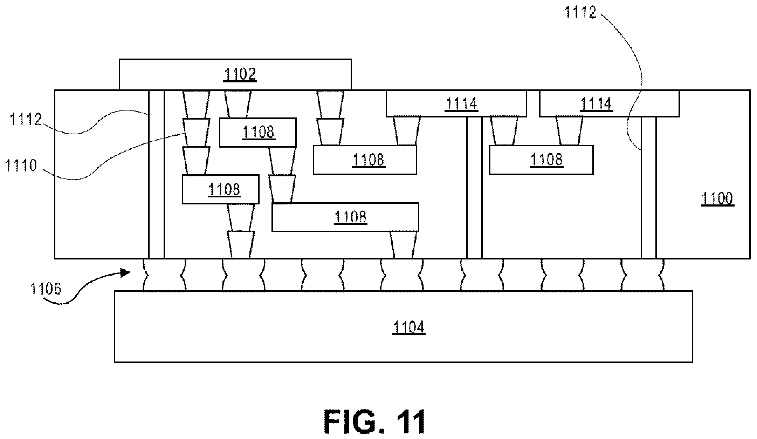

FIG. 11 illustrates an interposer 1100 that includes one or more embodiments of the invention. The interposer 1100 is an intervening substrate used to bridge a first substrate 1102 to a second substrate 1104. The first substrate 1102 may be, for instance, an integrated circuit die. The second substrate 1104 may be, for instance, a memory module, a computer motherboard, or another integrated circuit die. Generally, the purpose of an interposer 1100 is to spread a connection to a wider pitch or to reroute a connection to a different connection. For example, an interposer 1100 may couple an integrated circuit die to a ball grid array (BGA) 1106 that can subsequently be coupled to the second substrate 1104. In some embodiments, the first and second substrates 1102/1104 are attached to opposing sides of the interposer 1100. In other embodiments, the first and second substrates 1102/1104 are attached to the same side of the interposer 1100. And in further embodiments, three or more substrates are interconnected by way of the interposer 1100.

The interposer 1100 may be formed of an epoxy resin, a fiberglass-reinforced epoxy resin, a ceramic material, or a polymer material such as polyimide. In further implementations, the interposer 1100 may be formed of alternate rigid or flexible materials that may include the same materials described above for use in a semiconductor substrate, such as silicon, germanium, or other group III-V or group IV materials.

The interposer 1100 may include metal interconnects 1108 and vias 1110, including but not limited to through-silicon vias (TSVs) 1112. The interposer 1100 may further include embedded devices 1114, including both passive and active devices. Such devices include, but are not limited to, capacitors, decoupling capacitors, resistors, inductors, fuses, diodes, transformers, sensors, or electrostatic discharge (ESD) devices. More complex devices such as radio-frequency (RF) devices, power amplifiers, power management devices, antennas, arrays, sensors, or MEMS devices may also be formed on the interposer 1100. In accordance with embodiments of the invention, apparatuses or processes disclosed herein may be used in the fabrication of interposer 1100.

Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

## Claims

1. An interconnect structure, comprising:
a first plurality of interconnect lines (352, 332) of a first metallization layer formed above a semiconductor substrate (351);
a second plurality of interconnect lines (356B) of a second metallization layer formed above the first metallization layer and extending in a first direction;
a third plurality of interconnect lines (354A, 334) of a third metallization layer formed above the second metallization layer and extending in the first direction, wherein the second plurality of interconnect lines and the third plurality of interconnect lines are staggered such that individual interconnect lines of the third plurality of interconnect lines are laterally offset from individual interconnect lines of the second plurality of interconnect lines; and
a via (356A, 336) coupling an individual interconnect line of the first plurality of interconnect lines to an individual interconnect line of the third plurality of interconnect lines,
wherein the via (356A, 336) is a varied width via and has a lower portion (336A, 346A) in contact with the individual interconnect line of the first plurality of interconnect lines and an upper portion (336B, 346B) in contact with the individual interconnect line of the third plurality of interconnect lines, the upper portion having a greater width in the first direction than the lower portion;
wherein the via is a barrier-less via in the sense that no barrier layer is intervening between the individual interconnect of the first plurality of interconnect lines and the via.

2. The interconnect structure of claim 1, further comprising a dielectric material adjacent to at least a portion of the individual interconnect lines of at least one of the first plurality of interconnect lines, the second plurality of interconnect lines and the third plurality of interconnect lines.

3. The interconnect structure of claim 1 or 2, further comprising air-gaps between the individual interconnect lines of the second plurality of interconnect lines.

4. The interconnect structure of claim 1 or 2, further comprising air-gaps between the individual interconnect lines of the third plurality of interconnect lines.

5. The interconnect structure of claim 1 or 2, wherein both the second plurality of interconnect lines and the third plurality of interconnect lines includes air-gaps between individual interconnect lines.

6. The interconnect structure of claim 1, 2, 3, 4 or 5, wherein the second plurality of interconnect lines and the third plurality of interconnect lines are at least partially surrounded by etch stop.

7. A system, comprising:
a storage component; and
an integrated circuit die coupled to the storage component, the integrated circuit die including an interconnect structure according to any of claims 1 to 6.

## Patentansprüche

1. Zwischenverbindungsstruktur, die Folgendes umfasst:
eine erste Vielzahl von Zwischenverbindungsleitungen (352, 332) einer ersten Metallisierungsschicht, die über einem Halbleitersubstrat (351) gebildet ist;
eine zweite Vielzahl von Zwischenverbindungsleitungen (356B) einer zweiten Metallisierungsschicht, die über der ersten Metallisierungsschicht gebildet ist und sich in einer ersten Richtung erstreckt;
eine dritte Vielzahl von Zwischenverbindungsleitungen (354A, 334) einer dritten Metallisierungsschicht, die über der zweiten Metallisierungsschicht gebildet ist und sich in der ersten Richtung erstreckt,
wobei die zweite Vielzahl von Zwischenverbindungsleitungen und die dritte Vielzahl von Zwischenverbindungsleitungen so versetzt angeordnet sind, dass einzelne Zwischenverbindungsleitungen der dritten Vielzahl von Zwischenverbindungsleitungen lateral von einzelnen Zwischenverbindungsleitungen der zweiten Vielzahl von Zwischenverbindungsleitungen versetzt sind; und
ein Via (356A, 336), das eine einzelne Zwischenverbindungsleitung der ersten Vielzahl von Zwischenverbindungsleitungen mit einer einzelnen Zwischenverbindungsleitung der dritten Vielzahl von Zwischenverbindungsleitungen koppelt,
wobei das Via (356A, 336) ein Via mit variierender Breite ist und einen unteren Teil (336A, 346A) in Kontakt mit der einzelnen Zwischenverbindungsleitung der ersten Vielzahl von Zwischenverbindungsleitungen und einen oberen Teil (336B, 346B) in Kontakt mit der einzelnen Zwischenverbindungsleitung der dritten Vielzahl von Zwischenverbindungsleitungen aufweist, wobei der obere Teil eine größere Breite in der ersten Richtung als der untere Teil aufweist;
wobei das Via in dem Sinne ein barrierefreies Via ist, dass keine Barriereschicht zwischen der einzelnen Zwischenverbindung der ersten Vielzahl von Zwischenverbindungsleitungen und dem Via liegt.

2. Zwischenverbindungsstruktur nach Anspruch 1, die ferner ein dielektrisches Material angrenzend an mindestens einen Teil der einzelnen Zwischenverbindungsleitungen der ersten Vielzahl von Zwischenverbindungsleitungen und/oder der zweiten Vielzahl von Zwischenverbindungsleitungen und/oder der dritten Vielzahl von Zwischenverbindungsleitungen umfasst.

3. Zwischenverbindungsstruktur nach Anspruch 1 oder 2, die ferner Luftspalte zwischen den einzelnen Zwischenverbindungsleitungen der zweiten Vielzahl von Zwischenverbindungsleitungen umfasst.

4. Zwischenverbindungsstruktur nach Anspruch 1 oder 2, die ferner Luftspalte zwischen den einzelnen Zwischenverbindungsleitungen der dritten Vielzahl von Zwischenverbindungsleitungen umfasst.

5. Zwischenverbindungsstruktur nach Anspruch 1 oder 2, wobei sowohl die zweite Vielzahl von Zwischenverbindungsleitungen als auch die dritte Vielzahl von Zwischenverbindungsleitungen Luftspalte zwischen einzelnen Zwischenverbindungsleitungen beinhalten.

6. Zwischenverbindungsstruktur nach Anspruch 1, 2, 3, 4 oder 5, wobei die zweite Vielzahl von Zwischenverbindungsleitungen und die dritte Vielzahl von Zwischenverbindungsleitungen zumindest teilweise von einem Ätzstoppelement umgeben sind.

7. System, das Folgendes umfasst:
eine Speicherkomponente; und
ein Integrierte-Schaltung-Die, das mit der Speicherkomponente gekoppelt ist, wobei das Integrierte-Schaltung-Die eine Zwischenverbindungsstruktur nach einem der Ansprüche 1 bis 6 beinhaltet.

## Revendications

1. Structure d'interconnexion, comprenant :
une première pluralité de lignes d'interconnexion (352, 332) d'une première couche de métallisation formée au-dessus d'un substrat semi-conducteur (351) ;
une deuxième pluralité de lignes d'interconnexion (356B) d'une deuxième couche de métallisation formée au-dessus de la première couche de métallisation et s'étendant selon une première direction ;
une troisième pluralité de lignes d'interconnexion (354A, 334) d'une troisième couche de métallisation formée au-dessus de la deuxième couche de métallisation et s'étendant dans la première direction,
la deuxième pluralité de lignes d'interconnexion et la troisième pluralité de lignes d'interconnexion étant décalées de telle sorte que des lignes d'interconnexion individuelles de la troisième pluralité de lignes d'interconnexion soient décalées latéralement par rapport à des lignes d'interconnexion individuelles de la deuxième pluralité de lignes d'interconnexion ; et
un via (356A, 336) couplant une ligne d'interconnexion individuelle de la première pluralité de lignes d'interconnexion à une ligne d'interconnexion individuelle de la troisième pluralité de lignes d'interconnexion,
le via (356A, 336) étant un via à largeur variable et ayant une partie inférieure (336A, 346A) en contact avec la ligne d'interconnexion individuelle de la première pluralité de lignes d'interconnexion et une partie supérieure (336B, 346B) en contact avec la ligne d'interconnexion individuelle de la troisième pluralité de lignes d'interconnexion, la partie supérieure ayant une plus grande largeur dans la première direction que la partie inférieure ;
le via étant un via sans barrière dans le sens où aucune couche barrière n'intervient entre l'interconnexion individuelle de la première pluralité de lignes d'interconnexion et le via.

2. Structure d'interconnexion selon la revendication 1, comprenant en outre un matériau diélectrique adjacent à au moins une partie des lignes d'interconnexion individuelles d'au moins l'une de la première pluralité de lignes d'interconnexion, de la deuxième pluralité de lignes d'interconnexion et de la troisième pluralité de lignes d'interconnexion.

3. Structure d'interconnexion selon la revendication 1 ou 2, comprenant en outre des entrefers entre les lignes d'interconnexion individuelles de la deuxième pluralité de lignes d'interconnexion.

4. Structure d'interconnexion selon la revendication 1 ou 2, comprenant en outre des entrefers entre les lignes d'interconnexion individuelles de la troisième pluralité de lignes d'interconnexion.

5. Structure d'interconnexion selon la revendication 1 ou 2, dans laquelle à la fois la deuxième pluralité de lignes d'interconnexion et la troisième pluralité de lignes d'interconnexion comprennent des entrefers entre des lignes d'interconnexion individuelles.

6. Structure d'interconnexion selon la revendication 1, 2, 3, 4 ou 5, dans laquelle la deuxième pluralité de lignes d'interconnexion et la troisième pluralité de lignes d'interconnexion sont au moins partiellement entourées par un arrêt de gravure.

7. Système comprenant :
un composant de stockage ; et
une puce de circuit intégré couplée au composant de stockage, la puce de circuit intégré comprenant une structure d'interconnexion selon l'une quelconque des revendications 1 à 6.
